# DEMANDE DE BREVET EUROPEEN

(11) **EP 1 076 366 A1**
(43) Date de publication de la demande: **14.02.2001**
(21) Numéro de dépôt: 00410095.4
(22) Date de dépôt: 08.08.2000
(51) Int. Cl.: H01L 29/747

(54) **Commutateur bidirectionnel à performances en commutation améliorées**

(30) Priorité: 09.08.1999 FR 9910413
(71) Demandeur: STMicroelectronics SA, 94250 Gentilly Cedex (FR)
(72) Inventeur: Duclos, Franck, 37000 Tours (FR); Simonnet, Jean-Michel, 37270 Veretz (FR); Ladiray, Olivier, 37270 Montlouis sur Loire (FR)
(74) Mandataire: de Beaumont, Michel

(57) **Abrégé**

L'invention concerne un commutateur bidirectionnel monolithique formé dans un substrat semiconducteur (1) d'un premier type de conductivité. Ce commutateur comprend un premier thyristor vertical principal (Th1) dont la couche de face arrière (2) est du deuxième type de conductivité, un deuxième thyristor vertical principal (Th2) dont la couche de face arrière (6) est du premier type de conductivité. Une structure de déclenchement de chacun des premier et deuxième thyristors principaux est disposée en regard de régions mutuellement éloignées des deux thyristors principaux dont les parties voisines correspondent à une région pour laquelle, pour le premier thyristor principal, on se trouve dans une zone de court-circuit entre cathode et gâchette de cathode.

## Description

La présente invention concerne la réalisation sous forme monolithique de commutateurs bidirectionnels de moyenne puissance.

Les commutateurs bidirectionnels statiques les plus courants sont les triacs. Un triac correspond à l'association en antiparallèle de deux thyristors. Il peut donc être connecté directement dans un réseau alternatif, par exemple le secteur. La gâchette d'un triac classique correspond à la gâchette de cathode de l'un au moins des deux thyristors qui le constituent et est référencée à l'électrode située sur la face avant de ce triac, c'est-à-dire la face qui comporte la borne de gâchette, alors que c'est l'autre face du triac qui est couramment reliée à un radiateur et à la masse.

On considérera ci-après plus particulièrement des commutateurs bidirectionnels du type décrit dans la demande de brevet européen N° 0817277 dont le déclenchement est assuré par application d'une tension entre une électrode de commande située sur la face avant du composant et une électrode principale située sur la face opposée du composant.

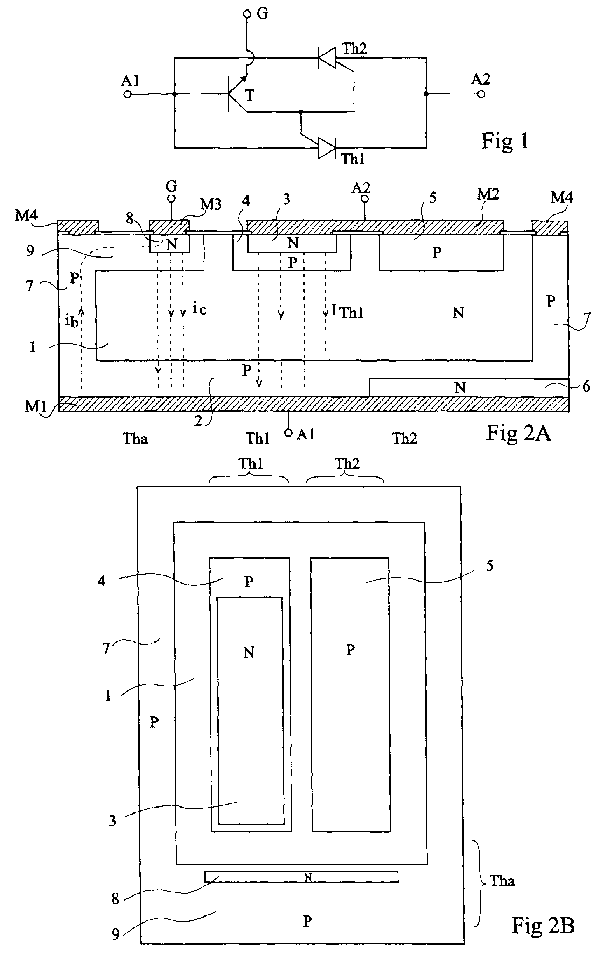

La figure 1 représente un schéma électrique équivalent d'un tel commutateur bidirectionnel. Une électrode G de commande du commutateur bidirectionnel est reliée à l'émetteur d'un transistor bipolaire T dont le collecteur est relié aux gâchettes d'anode de premier et deuxième thyristors Th1 et Th2 placés en antiparallèle entre deux bornes A1 et A2. La borne A1 correspond à l'anode du thyristor Th1 et à la cathode du thyristor Th2. La borne A1 est également reliée à la base du transistor T. La borne A2 correspond à l'anode du thyristor Th2 et à la cathode du thyristor Th1.

La figure 2A est une vue en coupe schématique d'un exemple de réalisation sous forme monolithique du commutateur bidirectionnel décrit en relation avec la figure 1. Le transistor T est réalisé dans la partie gauche de la figure, le thyristor Th1 au centre et le thyristor Th2 à droite. Comme on le verra ci-après, ceci ne correspond pas à la disposition effective des divers composants dont un exemple sera donné en relation avec la vue de dessus de la figure 2B mais est uniquement destiné à expliquer le fonctionnement de la structure.

La structure de la figure 2A est formée à partir d'un substrat semiconducteur 1 faiblement dopé de type N. L'anode du thyristor Th1 correspond à une couche 2 de type P qui est formée du côté de la face arrière du substrat 1. Sa cathode correspond à une région 3 de type N formée du côté de la face avant dans un caisson 4 de type P. L'anode du thyristor Th2 correspond à un caisson 5 de type P formé du côté de la face avant et sa cathode correspond à une région 6 de type N formée du côté de la face arrière dans la couche 2. La périphérie de la structure est constituée d'une région 7 de type P fortement dopée s'étendant depuis la face avant jusqu'à la couche 2 de type P. De façon classique, la région 7 est obtenue par diffusion profonde à partir des deux faces du substrat. La face arrière est revêtue d'une métallisation M1 correspondant à la première borne A1 du commutateur bidirectionnel. Les faces supérieures des régions 3 et 5 sont revêtues d'une deuxième métallisation M2 correspondant à la deuxième borne A2 du commutateur bidirectionnel. Une région 8 de type N est formée, du côté de la face avant, dans un caisson 9 de type P en contact avec la région périphérique 7. La surface de la région 8 est solidaire d'une métallisation M3 reliée à la borne de commande G du commutateur bidirectionnel. Une métallisation M4 peut être formée sur la surface supérieure de la région périphérique 7. La métallisation M4 n'est pas connectée à une borne externe. A titre de variante, le caisson 9 peut être séparé de la région périphérique 7 et relié électriquement à celle-ci par l'intermédiaire de la métallisation M4.

Le fonctionnement de ce commutateur bidirectionnel est le suivant.

Quand la borne A2 est négative par rapport à la borne A1, c'est le thyristor Th1 qui est susceptible d'être passant. Si on applique sur la borne G une tension suffisamment négative par rapport à la métallisation M1, la jonction base-émetteur du transistor T est polarisée en direct et ce transistor devient passant. Il circule donc un courant vertical i_{c} représenté en pointillés en figure 2A depuis la métallisation M1, à travers la jonction en direct entre la couche 2 et le substrat 1 puis dans les régions 1, 9 et 8 correspondant au transistor T. Il y a donc une génération de porteurs au niveau de la jonction entre le substrat 1 et le caisson 9 près de la jonction entre le substrat 1 et le caisson 4 et le thyristor Th1 est mis en état de conduction. On peut également considérer que l'on a provoqué l'amorçage d'un thyristor auxiliaire vertical NPNP Tha comprenant les régions 8-9-1-2, dont la région 9 constitue la région de gâchette de cathode.

Quand la borne A2 est positive par rapport à la borne A1, c'est le thyristor Th2 qui est susceptible d'être passant. L'application d'une tension négative sur la borne G rend passant le transistor T. Les porteurs présents au voisinage de la jonction entre le substrat 1 et la couche 2 entraînent la mise en conduction du thyristor Th2 comme on le comprendra mieux en se référant à la vue de dessus schématique de la figure 2B dans laquelle on voit que la région correspondant au transistor T est voisine d'une portion de chacun des thyristors Th1 et Th2.

Comme le montre également la vue de dessus de la figure 2B, le transistor de déclenchement T (qui constitue une partie du thyristor auxiliaire Tha) est disposé en regard d'une partie du thyristor vertical Th1 et d'une partie du thyristor vertical Th2. Plus particulièrement, le thyristor Th1 doit être très sensible au voisinage de sa zone de déclenchement, c'est-à-dire qu'il ne doit pas comprendre de région de court-circuit entre sa cathode et sa gâchette de cathode. Ainsi, la métallisation M2, non représentée en figure 2B, qui est en contact avec la région 3 et le caisson 5, n'est en contact avec la région 4 que dans une zone opposée à la zone de déclenchement.

Un inconvénient de la structure représentée en figure 2 est qu'elle présente une mauvaise caractéristique de tenue en tension à la commutation en présence d'une charge inductive, c'est-à-dire que, quand on souhaite interrompre la conduction du commutateur bidirectionnel, celui-ci, et plus particulièrement le thyristor Th1, risque de se remettre en conduction alors que son électrode de commande n'est plus activée.

Un objet de la présente invention est de proposer un nouveau mode de réalisation sous forme monolithique d'un commutateur bidirectionnel du type susmentionné qui présente une meilleure tenue en tension à la citation, notamment sur charge inductive.

Pour atteindre cet objet, la présente invention prévoit un commutateur bidirectionnel monolithique formé dans un substrat semiconducteur d'un premier type de conductivité ayant une face avant et une face arrière, comprenant un premier thyristor vertical principal dont la couche de face arrière est du deuxième type de conductivité, un deuxième thyristor vertical principal dont la couche de face arrière est du premier type de conductivité, et des structures de déclenchement de chacun des premier et deuxième thyristors principaux disposées en regard de régions mutuellement éloignées des deux thyristors principaux dont les parties voisines correspondent à une région pour laquelle, pour le premier thyristor principal, on se trouve dans une zone de court-circuit entre cathode et gâchette de cathode.

Selon un mode de réalisation de la présente invention, le commutateur bidirectionnel comporte un premier thyristor vertical auxiliaire dont la couche de face arrière est du deuxième type de conductivité et est commune avec celle du premier thyristor principal, un deuxième thyristor vertical auxiliaire dont la couche de face arrière est du deuxième type de conductivité et est commune avec celle du premier thyristor, les bornes principales de face supérieure des premier et deuxième thyristors auxiliaires constituant une même borne de commande, une région périphérique du deuxième type de conductivité reliant notamment la couche de face arrière des thyristors auxiliaires aux couches de gâchette de ces thyristors auxiliaires situées de l'autre côté du substrat, une première métallisation de face arrière, une deuxième métallisation du côté de la face avant reliant les régions de face avant des premier et deuxième thyristors.

Selon un mode de réalisation de la présente invention, le commutateur bidirectionnel comporte une région supplémentaire ayant une fonction d'isolement entre la face arrière du premier thyristor auxiliaire et la première métallisation.

Selon un mode de réalisation de la présente invention, le commutateur bidirectionnel comporte dans le substrat entre la face supérieure de chacun des thyristors principaux et la face supérieure de chacun des thyristors auxiliaires une région du premier type de conductivité plus fortement dopée que le substrat, connectée à l'autre région.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma électrique d'un commutateur bidirectionnel classique ;
les figures 2A et 2B représentent respectivement une vue en coupe et une vue de dessus d'un mode de réalisation classique du commutateur bidirectionnel de la figure 1 ;
les figures 3A et 3B représentent respectivement une vue en coupe et une vue de dessus d'un mode de réalisation d'un commutateur bidirectionnel selon la présente invention ;
les figures 4A et 4B représentent respectivement une vue en coupe et une vue de dessus d'un autre mode de réalisation d'un commutateur bidirectionnel selon la présente invention ; et
les figures 5A et 5B représentent respectivement une vue en coupe et une vue de dessus d'un autre mode de réalisation d'un commutateur bidirectionnel selon la présente invention.

Par souci de clarté, les mêmes éléments ont été désignés par les mêmes références aux différentes figures. De plus, comme cela est habituel dans la représentation des circuits intégrés, les figures 2 à 5 ne sont pas tracées à l'échelle.

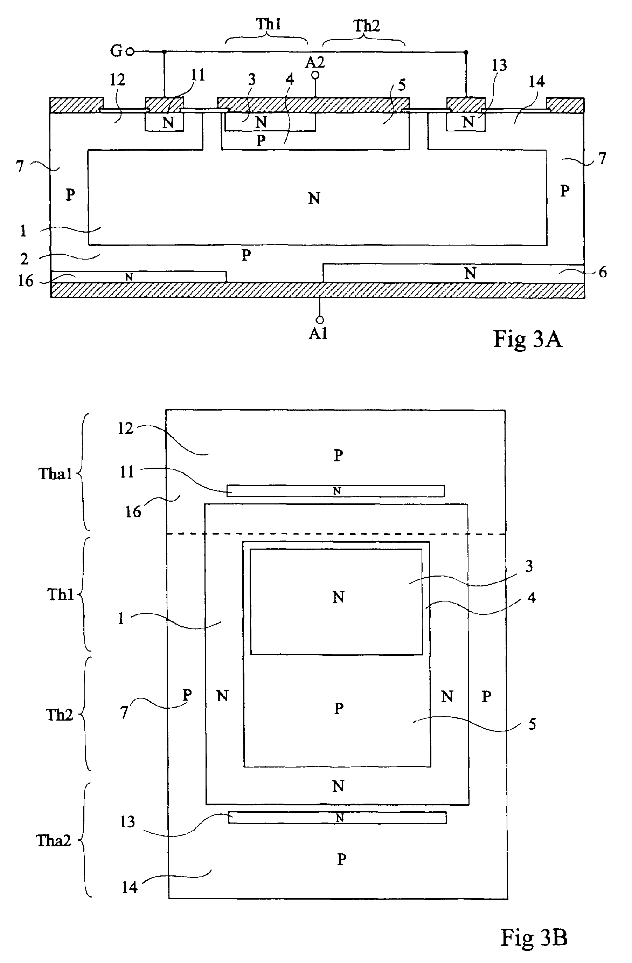

Comme le représente la vue en coupe de la figure 3A, un commutateur bidirectionnel selon un mode de réalisation de la présente invention comprend, comme celui de la figure 2A, un commutateur principal comportant des thyristors Th1 et Th2. Le thyristor Th1 comprend, de la face supérieure vers la face inférieure, une région 3 de type N, un caisson 4 de type P, le substrat 1 de type N, et une couche 2 de type P. Le thyristor Th2 comprend de la face supérieure à la face inférieure, un caisson 5 de type P, le substrat 1, la couche 2 et une région 6 de type N. Dans ce mode de réalisation, les deux thyristors partagent du côté de la face supérieure une même région P qui constitue la couche d'anode du thyristor Th2 et la couche de gâchette de cathode du thyristor Th1. On notera à ce propos que l'on aurait pu prévoir en figure 2B une continuité entre les parties supérieures des régions 4 et 5 étant donné qu'il existe un court-circuit par la métallisation M2 entre la région 3 de cathode du thyristor Th1 et la partie supérieure de la région 4 de gâchette d'anode et que cette métallisation M2 est également en contact avec la région d'anode 5 du thyristor Th2.

La différence principale entre la présente invention et le mode de réalisation antérieur d'un commutateur bidirectionnel décrit en relation avec les figures 2A et 2B se voit mieux en considérant aussi la vue de dessus de la figure 3B. Au lieu de prévoir un seul thyristor auxiliaire de déclenchement d'un côté de la structure (dans la partie gauche de la vue de dessus de la figure 2A et dans la partie basse de la vue de dessus de la figure 2B), la présente invention prévoit deux structures de déclenchement dont chacune est destinée à provoquer le déclenchement de l'un des deux thyristors constitutifs du commutateur bidirectionnel. La structure de déclenchement du thyristor Th1 comprend une région 11 de type N disposée dans un caisson 12 de type P qui est relié à la couche 2 de type P de la face arrière par une diffusion profonde 7. L'ensemble de la région 11, du caisson 12, du substrat 1 et de la couche 2 constitue un premier thyristor auxiliaire vertical Tha1. La région de déclenchement du thyristor Th2 comprend du côté de la face supérieure de la structure une région 13 de type N formée dans un caisson 14 de type P, ce caisson 14 rejoignant la région 7 de diffusion profonde qui, de préférence, s'étend sur toute la périphérie du composant. L'ensemble de la région 13, du caisson 14, du substrat 1 et de la couche 2 constitue un deuxième thyristor auxiliaire vertical Tha2.

En outre, la présente invention prévoit de façon optionnelle mais préférentielle qu'une région 16 de type N soit disposée du côté de la face arrière de la structure sensiblement sous le thyristor auxiliaire Tha1 de déclenchement du thyristor Th1. Dans la vue de dessus de la figure 3B, cette région 16 s'étend sensiblement depuis la partie supérieure de la figure jusqu'à l'aplomb du caisson P 4.

Il s'avère que la structure des figures 3A et 3B a une bien meilleure tenue à la commutation sur charge inductive que celle des figures 2A-2B. La demanderesse attribue ce fait à ce que, dans le cas de la structure des figures 2A-2B, au moment où le thyristor Th2 cesse de conduire, il existe des charges stockées dans les zones correspondant au thyristor Th2 et notamment près de la région du thyristor Th1 proche de la région de déclenchement 8, cette région du thyristor Th1 étant particulièrement sensible à un déclenchement. Par contre, dans le cas de la structure des figures 3A-3B, au moment où le courant s'annule dans le thyristor Th2, il existe bien entendu aussi des charges stockées dans les zones correspondant à ce thyristor. Mais la seule région de voisinage entre le thyristor Th2 et le thyristor Th1 est la partie inférieure du thyristor Th1 dans la figure 3B, c'est-à-dire la partie de ce thyristor dans laquelle il existe un court-circuit entre cathode et gâchette de cathode. Cette région est particulièrement peu sensible et le thyristor Th1 n'est alors pas susceptible de se redéclencher.

Au déclenchement, on notera que, quand on applique une tension sur la borne G, propre à mettre en conduction l'un ou l'autre des thyristors Th1 et Th2, un courant de préamorçage circulera entre l'électrode A1 et la borne G, ce courant se partageant en un courant base-émetteur 12-11 du transistor (T1) de commande du thyristor Th1 et un courant base-émetteur 14-13 du transistor (T2) de commande du thyristor Th2. Quand par exemple on veut déclencher le thyristor Th1, ceci veut dire qu'une petite perte se produit dans le transistor T2 alors que l'on veut mettre en conduction le transistor T1.

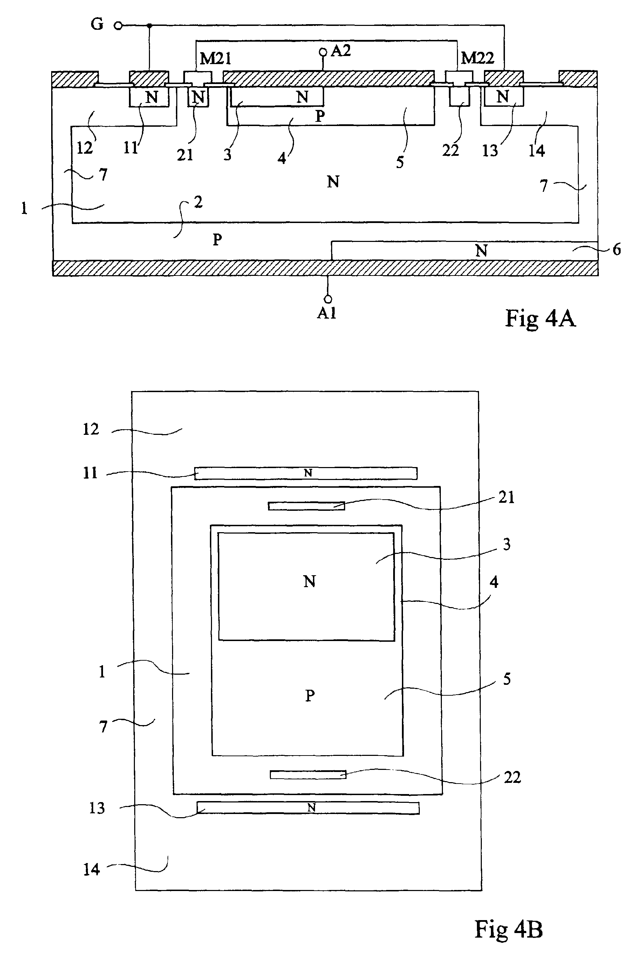

Le mode de réalisation des figures 4A-4B permet de réduire cette perte qui, de toute façon, n'est pas fondamentale.

Dans la structure des figures 4A-4B, on a rajouté par rapport à la structure des figures 3A-3B, une région 21 de type N entre le caisson P 4-5 et le caisson P 12 et une région 22 de type N entre le caisson P 4-5 et le caisson P 14. Comme on le voit en figure 4B, ces régions N 21 et 22 à niveau de dopage très élevé ne constituent pas une région d'arrêt de canal étant donné qu'elles n'entourent pas complètement le caisson 4-5. Les régions 21 et 22 sont solidaires de métallisations M21 et M22 connectées l'une à l'autre. Ainsi, quand la structure est polarisée entre les bornes A1 et A2 pour amorcer le transistor correspondant à l'un des thyristors, par exemple le thyristor Th1, le courant d'amorçage perdu dans le transistor opposé est récupéré par la zone N⁺ opposée (22) et est réinjecté vers la zone N⁺ (21), proche de la zone d'amorçage du thyristor Th1 et participe à son déclenchement. L'inverse se produit quand on veut commander le thyristor Th2.

Selon une autre variante de l'invention, on peut maintenir le mode de réalisation des figures 4A et 4B en supprimant la région 13. Ceci ne modifie pas sensiblement le déclenchement du transistor pilote du thyristor Th1. Toutefois, quand la polarisation est telle que c'est le thyristor Th2 qui est susceptible d'être amorcé, on notera que les électrons injectés par le transistor pilote du thyristor Th1 sont réinjectés par la région N⁺ 22 pour permettre un amorçage du thyristor Th2. Cette disposition dégrade en fait légèrement les performances d'amorçage du thyristor Th2 mais permet de réduire la taille de la puce sans modifier la surface active des thyristors.

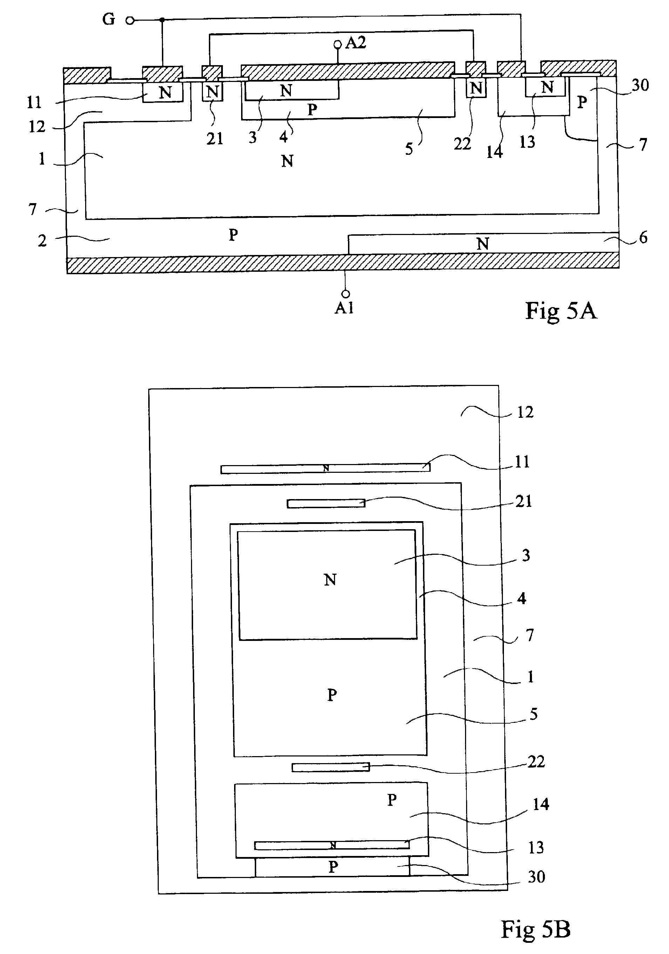

Les figures 5A et 5B représentent respectivement une vue en coupe et une vue de dessus d'un autre mode de réalisation d'un commutateur bidirectionnel selon la présente invention, adapté à recevoir un signal de commande positif ou négatif sur la borne G.

La structure des figures 5A et 5B est similaire à celle des figures 4A et 4B, sauf que :
- le caisson 14 n'est plus en contact avec le mur d'isolement 7 mais en est séparé par une région 30 faiblement dopée de type P ;
- la connexion de grille est comme précédemment reliée à la région 11 du premier transistor pilote. Par contre elle n'est plus reliée à la région 13 de type N⁺ du deuxième transistor pilote mais à la région de caisson 14 ;
- la région 13 est reliée par une métallisation à la face supérieure du mur d'isolement 7.
Avec une telle structure, le transistor pilote T1 situé à gauche de la vue en coupe de la figure 5A et en haut de la vue de dessus de la figure 5B, fonctionne pour l'amorçage du système quand la borne de gâchette est négative par rapport à la borne A1, que la borne A2 soit positive ou négative par rapport à la borne A1 ; et le transistor pilote situé à droite de la vue en coupe de la figure 5A et en bas de la vue de dessus de la figure 5B sert à l'amorçage avec une borne de commande G positive par rapport à la borne A1, que la borne A2 soit positive ou négative par rapport à cette borne A1.

Bien entendu, la présente invention est susceptible de diverses variantes et modifications qui apparaîtront à l'homme de l'art. En particulier, diverses variantes des deux thyristors principaux peuvent être imaginées, la caractéristique fondamentale de la présente invention étant que les zones d'amorçage préférentielles de chacun des thyristors sont opposées et que la région adjacente des deux thyristors est une région de faible sensibilité de déclenchement.

## Revendications

1. Commutateur bidirectionnel monolithique formé dans un substrat semiconducteur (1) d'un premier type de conductivité ayant une face avant et une face arrière, comprenant :
un premier thyristor vertical principal (Th1) dont la couche de face arrière (2) est du deuxième type de conductivité,
un deuxième thyristor vertical principal (Th2) dont la couche de face arrière (6) est du premier type de conductivité,
une structure de déclenchement de chacun des premier et deuxième thyristors principaux,
caractérisé en ce que lesdites structures de déclenchement sont disposées en regard de régions mutuellement éloignées des deux thyristors principaux dont les parties voisines correspondent à une région pour laquelle, pour le premier thyristor principal, on se trouve dans une zone de court-circuit entre cathode et gâchette de cathode.

2. Commutateur bidirectionnel selon la revendication 1, caractérisé en ce qu'il comporte :
un premier thyristor vertical auxiliaire (Tha1) dont la couche de face arrière (2) est du deuxième type de conductivité et est commune avec celle du premier thyristor principal (Th1),
un deuxième thyristor vertical auxiliaire (Tha2) dont la couche de face arrière est du deuxième type de conductivité et est commune avec celle du premier thyristor, les bornes principales de face supérieure des premier et deuxième thyristors auxiliaires constituant une même borne de commande,
une région périphérique (7) du deuxième type de conductivité reliant notamment la couche de face arrière des thyristors auxiliaires aux couches de gâchette de ces thyristors auxiliaires situées de l'autre côté du substrat,
une première métallisation (M1) de face arrière,
une deuxième métallisation (M2) du côté de la face avant reliant les régions de face avant des premier et deuxième thyristors.

3. Commutateur bidirectionnel selon la revendication 2, caractérisé en ce qu'il comporte une région supplémentaire (10) ayant une fonction d'isolement entre la face arrière du premier thyristor auxiliaire (Tha1) et la première métallisation (M1).

4. Commutateur bidirectionnel selon la revendication 2, caractérisé en ce qu'il comporte dans le substrat (1) entre la face supérieure de chacun des thyristors principaux et la face supérieure de chacun des thyristors auxiliaires une région (21, 22) du premier type de conductivité plus fortement dopée que le substrat, connectée à l'autre région.
